# EUROPÄISCHE PATENTSCHRIFT

(11) **EP 2 529 398 B1**
(45) Veröffentlichungstag und Bekanntmachung des Hinweises auf die Patenterteilung: **30.03.2016**
(21) Anmeldenummer: 11708182.8
(22) Anmeldetag: 19.01.2011
(51) Int. Cl.: H01L 23/498, H01L 23/00

(54) **VERBESSERUNG DER EBENHEIT DURCH FREISCHNITTE AN DEN PRÄGEN**
IMPROVING THE EVENNESS BY MEANS OF CUTOUTS ON THE EMBOSSING POINTS
AMÉLIORATION DE LA PLANÉITÉ PAR DES DÉCOUPES NON GUIDÉES SUR LES ESTAMPAGES

(30) Priorität: 25.01.2010 DE 102010005771
(43) Veröffentlichungstag der Anmeldung: 05.12.2012
(73) Patentinhaber: Heraeus Deutschland GmbH & Co. KG, 63450 Hanau (DE)
(72) Erfinder: HERRERO SANCHEZ, Jose, 63452 Hanau (DE); PANEBIANCO, Salvatore, 63598 Linsengericht (DE); MICHALEK, Stefan, 63654 Büdingen (DE)
(74) Vertreter: Sterzel, Roland
(86) Internationale Anmeldenummer: PCT/EP2011/000194
(87) Internationale Veröffentlichungsnummer: WO 2011/088987

(56) Entgegenhaltungen:
- EP-A2- 1 329 952
- DE-A1-102007 033 369

## Beschreibung

Die vorliegende Erfindung betrifft ein modulares Metallband, ein Verfahren zur Herstellung dieses modularen Metallbands und ein Bauteil, das ein Modul dieses modularen Metallbands umfasst.

Bei der Herstellung von kontaktlosen Chipkarten werden üblicherweise Leiterbahnen aus einer Metallfolie gestanzt. Dabei entstehen unter anderem ein Trägerbereich (auch Inselbereich genannt), auf dem später der Chip aufgebracht wird, sowie Kontaktbereiche (auch Antennenbereiche genannt), mit denen der Chip später leitend verbunden wird. Der Trägerbereich ist von den Kontaktbereichen durch Ausstanzungen räumlich weitestgehend getrennt und mit der übrigen Metallfolie über zwei aus der Metallfolie ausgebildete, schmale Stegen (Massenstege) verbunden.

Durch die Ausbildung der Metallfolie als langgestreckter Filmstreifen mit einer periodischen, modularen Anordnung desselben Leiterbahnmusters können die Chips mit Hilfe eines Automaten aufgebracht und gewöhnlich mit den Kontaktbereichen mittels Bonddrähten elektrisch kontaktiert werden. Nach der Kontaktierung wird der Chip mit Vergussmasse überzogen. Sowohl durch die Kontaktierung mit den Bonddrähten als auch durch die Überziehung mit Vergussmasse wird der Trägerbereich an der Metallfolie fixiert. Anschließend werden die Chips mit dem umgebenden Leiterbahnmuster als ein Stück aus dem Filmstreifen ausgestanzt und in die entsprechenden Teile der Chipkarten eingesetzt.

Es kann prozesstechnisch erwünscht sein, die Elektronik des Chips zu testen, wenn sich dieser noch auf der Metallfolie befindet. Einige Tests gelingen, wenn der Trägerbereich an den Stegen in Position gehalten wird. Für bestimmte Tests müssen jedoch sämtliche leitenden Verbindungen zwischen dem Chip und der Metallfolie unterbrochen werden. Durch das Kappen der Verbindungen einschließlich der beiden Stege verliert der Trägerbereich seinen Halt.

Um den Trägerbereich nach dem Stanzen in Position zu halten, schlägt die EP 1329952 A2 vor, auf dem Chip eine isolierende tragende Schicht aus Vergussmasse aufzubringen, die über den Chip hinausreicht und in Verbindung mit der umgebenden Metallfolie steht. Als besonders vorteilhaft hat es sich erwiesen, zusätzlich Unterschneidungen an den Kontaktbereichen vorzusehen, in die Vergussmasse fließen kann, um den Halt zu verstärken. Nach dem Aushärten ist so die ausgehärtete, den Chip umgebende Vergussmasse mit den Trägerbereichen durch die Unterschneidungen verankert.

Diese Unterschneidungen werden gewöhnlich durch Prägen der Metallfolie an den Kontaktbereichen geschaffen. Dabei kommt es zwangsläufig zu einer Verdrängung des eingeprägten Materials der Metallfolie. Das Metall wird vornehmlich in Richtung der Kontaktbereiche verdrängt, woraus Spannungen resultieren, die zu Unebenheiten in diesem Bereich der Metallfolie führen. Besonders ausgeprägt tritt dieser Effekt an den Stellen der Kontaktbereiche auf, die die Ecken des Trägerbereichs umlaufen. In diesem Fall kommt es aufgrund des nichtlinearen Verlaufs der Prägestelle zu einer starken Verdrängung des geprägten Metalls in Richtung der benachbarten Kontaktbereiche und zu erhöhten Spannungen. Die dabei entstehenden Unebenheiten beeinflussen die Qualität der erzeugten Strukturen maßgeblich.

Erfindungsgemäß besteht daher die Aufgabe, ein modulares Metallband zur Erzeugung von Leiterbahnstrukturen zur Verfügung zu stellen, das Unterschneidungen in den Kontaktbereichen enthält und frei von durch Spannungen beim Erzeugen dieser Unterschneidungen hervorgerufenen Unebenheiten ist.

Eine weitere Aufgabe besteht darin, ein Verfahren zur Herstellung dieses modularen Metallbands bereitzustellen.

Erfindungsgemäß besteht eine weitere Aufgabe in der Bereitstellung eines Bauteils, das ein Modul des vorstehend beschriebenen modularen Metallbands und ein elektronisches Bauelement umfasst.

Diese Aufgaben werden gelöst durch die Gegenstände der unabhängigen Ansprüche.

Folglich wird ein modulares Metallband zur Verfügung gestellt, wobei das einzelne Modul einen Trägerbereich für die Aufbringung eines elektronischen Bauelements, der wenigstens zwei zueinander parallele Seiten aufweist, die durch Ecken begrenzt sind, Kontaktbereiche, die die wenigstens zwei zueinander parallelen Seiten des Trägerbereichs und die Ecken der wenigstens zwei zueinander parallelen Seiten des Trägerbereichs vollständig umlaufen, wobei die Kontaktbereiche in den Bereichen, die die Ecken der wenigstens zwei zueinander parallelen Seiten des Trägerbereichs umlaufen, abgerundet sind, und Ausstanzungen, die den Trägerbereich von den Kontaktbereichen trennen, enthält, wobei wenigstens die Kontaktbereiche Unterschneidungen aufweisen, die mit den Ausstanzungen in Verbindung stehen, und die Kontaktbereiche in den abgerundeten Bereichen Schlitze aufweisen, die mit den Ausstanzungen in Verbindung stehen.

Ferner wird ein Verfahren zur Herstellung eines modularen Metallbands bereitgestellt, bei dem man
(i) eine Metallfolie bereitstellt,
(ii) in die Metallfolie Module stanzt, die einen Trägerbereich, Kontaktbereiche, Ausstanzungen und Schlitze umfassen,
   wobei der Trägerbereich wenigstens zwei zueinander parallele Seiten aufweist, die durch Ecken begrenzt sind,
   die Kontaktbereiche die wenigstens zwei zueinander parallelen Seiten des Trägerbereichs und die Ecken der wenigstens zwei zueinander parallelen Seiten des Trägerbereichs vollständig umlaufen, wobei die Kontaktbereiche in den Bereichen, die die Ecken der wenigstens zwei zueinander parallelen Seiten des Trägerbereichs umlaufen, abgerundet sind,
   die Ausstanzungen den Trägerbereich von den Kontaktbereichen trennen und die Schlitze in den abgerundeten Bereichen der Kontaktbereiche angebracht sind und mit den Ausstanzungen in Verbindung stehen, und
(iii) die Kontaktbereiche mit Prägungen versieht, um Unterschneidungen zu schaffen, die mit den Ausstanzungen in Verbindung stehen.

Darüber hinaus wird ein Bauteil zur Verfügung gestellt, umfassend
(i) ein Modul eines modularen Metallbands, aufweisend einen Trägerbereich für die Aufbringung eines elektronischen Bauelements, der wenigstens zwei zueinander parallele Seiten aufweist, die durch Ecken begrenzt sind, Kontaktbereiche, die die wenigstens zwei zueinander parallelen Seiten des Trägerbereichs und die Ecken der wenigstens zwei zueinander parallelen Seiten des Trägerbereichs vollständig umlaufen, wobei die Kontaktbereiche in den Bereichen, die die Ecken der wenigstens zwei zueinander parallelen Seiten des Trägerbereichs umlaufen, abgerundet sind, und Ausstanzungen, die den Trägerbereich von den Kontaktbereichen trennen, wobei wenigstens die Kontaktbereiche Unterschneidungen aufweisen, die mit den Ausstanzungen in Verbindung stehen, und die Kontaktbereiche in den abgerundeten Bereichen Schlitze aufweisen, die mit den Ausstanzungen in Verbindung stehen, und
(ii) ein elektronisches Bauelement, das auf dem Trägerbereich des Moduls aufgebracht ist, wobei das elektronische Bauelement von Vergussmasse überzogen ist und sich Vergussmasse in den Unterschneidungen befindet, um eine Verankerung der das elektronische Bauelement umgebenden Vergussmasse mit den Kontaktbereichen zu schaffen.

Die vorliegende Erfindung wird nachstehend unter Bezugnahme auf Figuren beschrieben, die jedoch die Erfindung nicht einschränken sollen. Es zeigen:

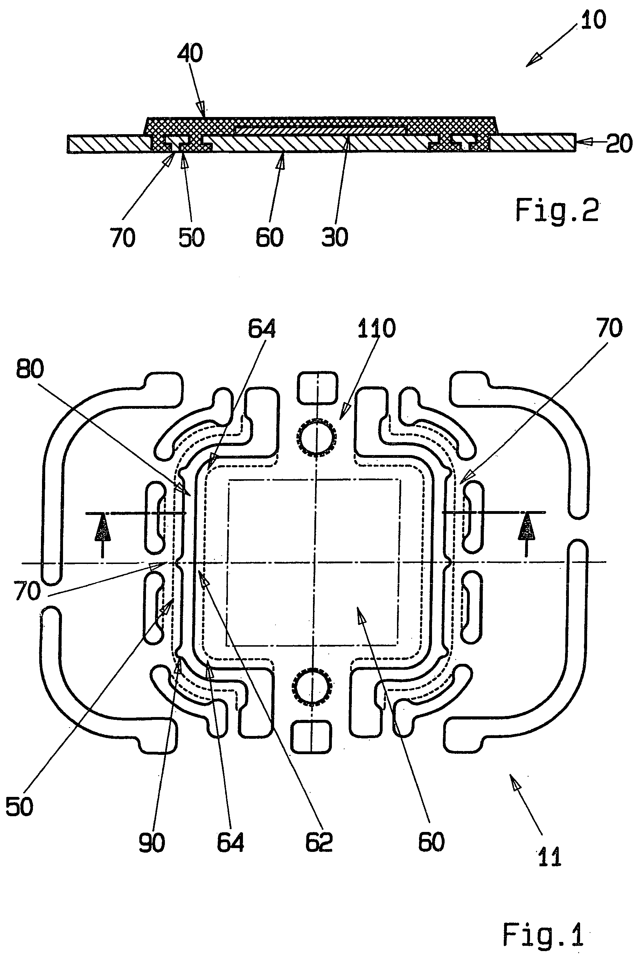

- Figur 1:: Draufsicht auf ein Modul des modularen Metallbands der vorliegenden Erfindung.
- Figur 2:: Schnitt durch das Modul des modularen Metallbands gemäß Figur 1. Der Schnitt erfolgt entlang der Ebene, die durch die beiden Pfeile in Figur 1 markiert ist. Zusätzlich sind noch ein Chip und die den Chip umgebende Vergussmasse gezeigt. Figur 2 zeigt somit letztlich den Schnitt durch das erfindungsgemäße Bauteil.

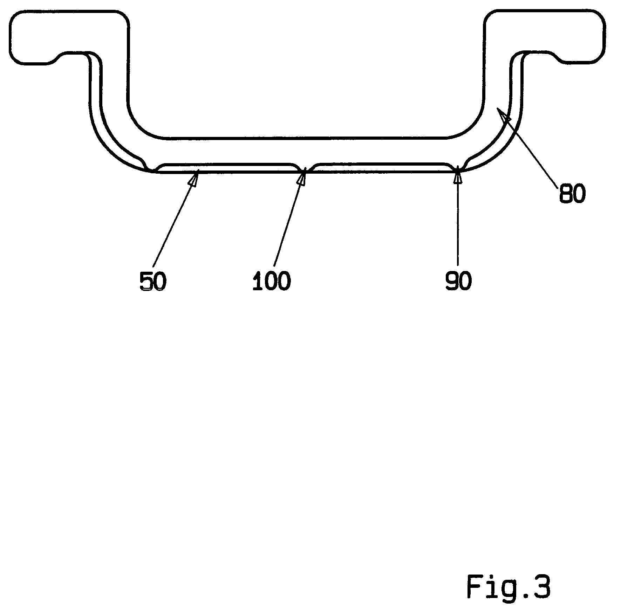

- Figur 3:: Eine den Trägerbereich von einem Kontaktbereich trennende Ausstanzung des Moduls des erfindungsgemäßen modularen Metallbands.

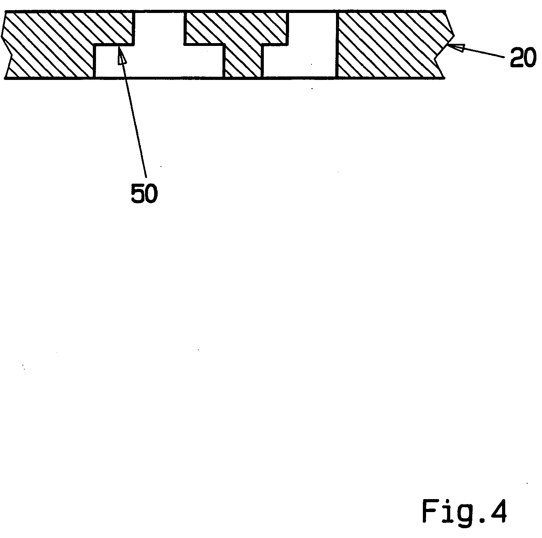

- Figur 4:: Eine Unterschneidung in einem Kontaktbereich eines Moduls des erfindungsgemäßen modularen Metallbands.

Erfindungsgemäß wird ein Metallband bereitgestellt.

Unter den Begriff Metallband fallen erfindungsgemäß Metallfolien (20), die ein Metall oder eine Metalllegierung aufweisen.

Das Metall der Metallfolie (20) oder der Metalllegierung kann edel oder unedel sein. Gemäß einer bevorzugten Ausführungsform handelt es sich bei dem Metall um Kupfer und bei der Metalllegierung um eine Kupfer-Legierung. Gemäß einer besonders bevorzugten Ausführungsform wird als Metalllegierung einer CuSn6-Legierung verwendet.

Das Metall oder die Metalllegierung können beschichtet oder unbeschichtet sein. Beispielsweise kann das Metall oder die Metalllegierung galvanisiert sein. Die Galvanisierung kann mit einem edlen oder unedlen Metall erfolgen, wobei Zinn, Silber und Gold besonders bevorzugt sind.

Vorzugsweise enthalten die Metallfolien (20) wenigstens 90 Gewichtsprozent, mehr bevorzugt wenigstens 95 Gewichtsprozent, noch mehr bevorzugt wenigstens 99 Gewichtsprozent und ganz besonders bevorzugt 100 Gewichtsprozent des Metalls oder der Metalllegierung.

Die Metallfolie (20) ist vorzugsweise ein Endlosband. Die Länge der Metallfolie (20) ist demnach nicht besonders eingeschränkt.

Das Metallband umfasst eine Vielzahl von Modulen (11). Unter Modulen (11) werden im Rahmen der Erfindung auf dem Metallband angeordnete Strukturen mit gleicher oder ähnlicher Beschaffenheit verstanden. Gemäß einer bevorzugten Ausführungsform sind die einzelnen Module (11) gleichmäßig auf dem Metallband angeordnet. Insbesondere können sich mehrere Module (11) nebeneinander entlang der Breite und entlang der Länge des Metallbands befinden.

Die einzelnen Module (11) umfassen erfindungsgemäß einen Trägerbereich (60). Dieser Trägerbereich (60) ist für die Aufbringung eines elektronischen Bauelements (30) geeignet. Bei dem elektronischen Bauelement (30) handelt es sich vorzugsweise um einen integrierten Schaltkreis, besonders bevorzugt um einen Chip. Der Trägerbereich (60) ist demnach so beschaffen, dass er ein elektronisches Bauelement (30) vorzugsweise vollständig aufnehmen kann.

Der Trägerbereich (60) weist wenigstens zwei zueinander parallele Seiten (62) auf, die durch Ecken (64) begrenzt sind. Die zwei zueinander parallelen Seiten (62) sind vorzugsweise eben. Die Ecken (64) können erfindungsgemäß auch abgerundet sein. Gemäß einer bevorzugten Ausführungsform weist der Trägerbereich (60) vier Seiten mit jeweils zwei zueinander parallelen Seitenpaaren auf. Der Trägerbereich (60) ist vorzugsweise rechteckig. Gemäß einer besonders bevorzugten Ausführungsform sind sämtliche Ecken des Rechtecks abgerundet.

Die einzelnen Module (11) umfassen ferner Kontaktbereiche (70). Gemäß einer bevorzugten Ausführungsform weist jedes Modul (11) wenigstens zwei, bevorzugt genau zwei, direkt an die dem Trägerbereich (60) benachbarten Ausstanzungen (80) angrenzende Kontaktbereiche (70) auf.

Die Kontaktbereiche (70) werden beim Einsatz mit dem elektronischen Bauelement (30) über geeignete Bondwerkzeuge elektrisch verbunden. Bei diesen Bondwerkzeugen handelt es sich vorzugsweise um Bonddrähte.

Die Kontaktbereiche (70) umlaufen die wenigstens zwei zueinander parallelen Seiten (62) des Trägerbereichs (60) und die Ecken (64) der wenigstens zwei zueinander parallelen Seiten (62) des Trägerbereichs (60) vollständig. Unter vollständig umlaufen wird erfindungsgemäß vorzugsweise verstanden, dass zwischen den wenigstens zwei zueinander parallelen Seiten (62) des Trägerbereichs (60) zu diesen Seiten (62) parallel verlaufende imaginäre Geraden denkbar sind, die die Kontaktbereiche (70) schneiden.

Ferner sind die Kontaktbereiche (70) in den Bereichen, die die Ecken (64) der wenigstens zwei zueinander parallelen Seiten (62) des Trägerbereichs (60) umlaufen, abgerundet. Unter Abrundung wird erfindungsgemäß jede Abweichung von der linearen Form verstanden.

Darüber hinaus sind Ausstanzungen (80) vorgesehen, die den Trägerbereich (60) von den Kontaktbereichen (70) trennen. Unter Ausstanzungen (80) werden demnach Aussparungen zwischen dem Trägerbereich (60) und den Kontaktbereichen (70) verstanden, die frei von Metallfolie (20) sind.

Neben den Ausstanzungen (80), die den Trägerbereich (60) von den Kontaktbereichen (70) trennen, können weitere Ausstanzungen vorgesehen sein, die ein gewünschtes Leiterbahnmuster erzeugen. Die Form und Ausgestaltung dieser weiteren Ausstanzungen ist nicht weiter eingeschränkt.

Ferner können die Module (11) Stege (110) aufweisen. Diese Stege (110) sind vorzugsweise integral mit dem Trägerbereich (60) verbunden. Unter integral verbunden wird in diesem Zusammenhang verstanden, dass Trägerbereich (60) und Stege (110) nicht durch Aussparungen voneinander getrennt sind. Dies schließt jedoch nicht aus, dass in den Stegen (110) selbst Aussparungen in der Form von Öffnungen vorhanden sein können. Die Stege (110) selbst werden von Ausstanzungen (80) gebildet. Die Ausstanzungen (80), die den Trägerbereich (60) von den Kontaktbereichen (70) trennen, verlaufen um die wenigstens zwei zueinander parallelen Seiten (62) des Trägerbereichs (60) und die Ecken (64) der wenigstens zwei zueinander parallelen Seiten (62) des Trägerbereichs (60). Vorzugsweise ist die Ausstanzung (80), die eine der wenigstens zwei zueinander parallelen Seiten (62) des Trägerbereichs (60) und die Ecken (64) dieser Seite (62) umläuft, nicht mit der Ausstanzung (80) verbunden, die die zu dieser Seite (62) parallele Seite (62) des Trägerbereichs (60) und die Ecken (64) dieser Seite (62) umläuft. Vielmehr geben diese beiden Ausstanzungen (80) die erfindungsgemäßen Stege (110) frei. Die Stege (110) trennen folglich die Kontaktbereiche (70) voneinander. Vorzugsweise sind die Kontaktbereiche (70) voneinander sowohl durch die erfindungsgemäßen Stege (110) als auch durch die Aussparungen getrennt. Dies schließt jedoch nicht aus, dass die Kontaktbereiche (70) durch umgebende Metallfolie (20) miteinander elektrisch leitend verbunden sein können.

Die Kontaktbereiche (70) weisen Unterschneidungen (50) auf, die mit den Ausstanzungen (80) in Verbindung stehen.

Als Unterschneidungen (50) werden erfindungsgemäß Ausnehmungen in dem Oberflächenbereich der Kontaktbereiche (70) verstanden, der später dem elektronischen Bauelement (30) abgewandt ist. Die Unterschneidungen (50) stehen mit den Ausstanzungen (80) in Fließverbindung. Dies ermöglicht das Fließen der Vergussmasse (40) sowohl in die Ausstanzungen (80) als auch in die Unterschneidungen (50). Folglich kommt es nach dem Überziehen des elektronischen Bauelements (30) mit Vergussmasse (40) und deren Aushärtung aufgrund der Unterschneidungen (50) in den Kontaktbereichen (70) zu einer Verankerung des elektronischen Bauelements (30) mit den Kontaktbereichen (70) über die Vergussmasse (40).

Neben den Kontaktbereichen (70) kann auch der Trägerbereich (60) Unterschneidungen (50) aufweisen, die mit den Ausstanzungen (80) in Verbindung stehen. Auch in diesem Fall stehen die Unterschneidungen (50) mit den Ausstanzungen (80) in Fließverbindung. Dies ermöglicht das Fließen der Vergussmasse (40) in die Ausstanzungen (80) und in die Unterschneidungen (50) der Kontaktbereiche (70) und des Trägerbereichs (60). Gemäß dieser Ausführungsform kommt es nach dem Überziehen des elektronischen Bauelements (30) mit Vergussmasse (40) und deren Aushärtung aufgrund der Unterschneidungen (50) in den Kontaktbereichen (70) und dem Trägerbereich (60) zu einer Verankerung des elektronischen Bauelements (30) mit den Kontaktbereichen (70) und dem Trägerbereich (60) über die Vergussmasse (40).

Ferner können auch die Stege (110) Unterschneidungen (50) aufweisen, die mit den Ausstanzungen (80), die den Trägerbereich (60) von den Kontaktbereichen (70) trennen, in Verbindung stehen. Weisen die Stege (110) selbst Aussparungen in der Form von Öffnungen auf, so können die Stege auch Unterschneidungen aufweisen, die mit diesen Aussparungen in Verbindung stehen.

Die Kontaktbereiche (70) weisen wenigstens in den abgerundeten Bereichen Schlitze (90) auf, die mit den Ausstanzungen (80) in Verbindung stehen. Die in den abgerundeten Bereichen der Kontaktbereiche (70) angeordneten Schlitze (90) stehen mit den Ausstanzungen (80) in Fließverbindung. Unter Schlitze (90) werden erfindungsgemäß Ausnehmungen verstanden, die beispielsweise ausgestanzt werden können und die beim Prägevorgang verdrängtes Material aufnehmen können.

Gemäß einer besonders bevorzugten Ausführungsform stehen die erfindungsgemäßen Unterschneidungen (50) in den Kontaktbereichen auch mit den Schlitzen (90) der Kontaktbereiche (70) in Verbindung.

Die einzelnen Schlitze (90) weisen vorzugsweise ein Volumen im Bereich von 0,00025 bis 0,00055 mm³, mehr bevorzugt ein Volumen im Bereich von 0,0003 bis 0,0005 mm³ und noch mehr bevorzugt ein Volumen im Bereich von 0,00035 bis 0,00045 mm³ auf.

Die einzelnen Schlitze (90) weisen eine Umfangslänge im Bereich von 0,30 bis 0,50 mm und mehr bevorzugt im Bereich von 0,35 bis 0,45 mm auf. Unter Umfangslänge eines Schlitzes (90) wird erfindungsgemäß die Länge des die Kontur eines Schlitzes (90) bildenden Abschnitts eines Kontaktbereichs (70) des Metallbands bezeichnet.

Die einzelnen Schlitze (90) weisen ferner eine Schlitzbreite im Bereich von 0,20 - 0,40 mm und mehr bevorzugt im Bereich von 0,25 - 0,35 mm auf. Unter Schlitzbreite wird erfindungsgemäß die Breite der die Schlitze (90) bildenden Aussparungen verstanden.

Gemäß einer weiteren bevorzugten Ausführungsform liegt der Anteil des Volumens eines Schlitzes (90) bezogen auf das Gesamtvolumen der Unterschneidung (50) eines Kontaktbereichs (70) im Bereich von 1,0 - 2,5 % und mehr bevorzugt im Bereich von 1,5 - 2 %. Durch dieses zusätzliche Volumen kann das beim Prägen der Unterschneidungen (50) verdrängte Material aufgenommen und das Entstehen von Spannungen wirksam verhindert werden.

Gemäß einer weiteren bevorzugten Ausführungsform vergrößert sich die Umfangslänge eines Kontaktbereichs (70) durch die Gegenwart eines Schlitzes (90) um 0,5 - 2 % und mehr bevorzugt um 0,9 - 1,5 %. Wenn die Unterschneidungen (50) der Kontaktbereiche (70) mit den Schlitzen (90) in Verbindung stehen, dann steigt durch die Gegenwart der Schlitze (90) die Kantenlänge der Kontaktbereiche (70) mit Unterschneidungen (50), die mit den Ausstanzungen (80) in Verbindung stehen, an, so dass nach dem Einbringen der Vergussmasse (40) mehr Fläche an Unterschneidungen (50) für eine Verankerung der das elektronische Bauelement (30) umgebenden Vergussmasse (40) mit den Kontaktbereichen (70) zur Verfügung steht.

Vorzugsweise ist in jedem abgerundeten Bereich der Kontaktbereiche (70), der eine Ecke (64) der wenigstens zwei zueinander parallelen Seiten (62) des Trägerbereichs (60) umläuft, wenigstens ein Schlitz (90), mehr bevorzugt genau ein Schlitz (90), vorhanden.

Gemäß einer bevorzugten Ausführungsform weisen die Kontaktbereiche (70) wenigstens in den abgerundeten Bereichen Schlitze (90) auf, wenn in dem Kontaktbereich (70), der eine der wenigstens zwei zueinander parallelen Seiten (62) des Trägerbereichs (60) und die Ecken (64) dieser Seite (62) umläuft, Schlitze (90) enthalten sind, die nicht parallel zueinander verlaufen.

Gemäß einer besonders bevorzugten Ausführungsform weisen die Kontaktbereiche (70) wenigstens in den abgerundeten Bereichen Schlitze (90) auf, wenn diese Schlitze (90) eine geometrische Form mit einer Achse aufweisen, die parallel zur Oberfläche des Kontaktbereichs (70) verläuft, wobei diese Achse nicht genau senkrecht zu den wenigstens zwei zueinander parallelen Seiten (62) des Trägerbereichs (60) verläuft. Vorzugsweise beträgt der Winkel, den diese Achse zu den wenigstens zwei zueinander parallelen Seiten (62) des Trägerbereichs (60) einnimmt, mehr als 90 Grad, mehr bevorzugt mehr als 95 Grad, noch mehr bevorzugt mehr als 100 Grad und ganz besonders bevorzugt mehr als 105 Grad.

Gemäß einer weiteren besonders bevorzugten Ausführungsform weisen die Kontaktbereiche (70) wenigstens in den abgerundeten Bereichen Schlitze (90) auf, wenn (i) die wenigstens zwei zueinander parallelen Seiten (62) des Trägerbereichs (60) eine Länge I, (ii) die Kontaktbereiche (70) einen geraden Abschnitt angrenzend zu den Ausstanzungen (80) und (iii) die Schlitze (90) eine geometrische Form mit einer Achse, die parallel zur Oberfläche des Kontaktbereichs (70) verläuft, wobei diese Achse nicht genau senkrecht zu den wenigstens zwei zueinander parallelen Seiten (62) des Trägerbereichs (60) verläuft, aufweisen, wobei der gerade Abschnitt der Kontaktbereiche (70), die die wenigstens zwei zueinander parallelen Seiten (62) des Trägerbereichs (60) und die Ecken (64) der wenigstens zwei zueinander parallelen Seiten (62) des Trägerbereichs (60) umlaufen, eine Länge von wenigstens (I - I/2), vorzugsweise (I - I/4), noch mehr bevorzugt (I - I/5) und ganz besonders bevorzugt (I - I/10) aufweist und innerhalb dieses geraden Abschnitts keine Schlitze (90) vorhanden sind, deren Achse, die parallel zur Oberfläche des Kontaktbereichs (70) verläuft, nicht genau senkrecht zu den wenigstens zwei zueinander parallelen Seiten (62) des Trägerbereichs (60) verläuft.

Zusätzlich können die Kontaktbereiche (70) auch in den nicht abgerundeten Bereichen Schlitze (100) aufweisen. Dabei kann es bevorzugt sein, dass sich jeweils ein Schlitz (100) eines nicht abgerundeten Bereichs genau mittig zwischen den Schlitzen (90) der abgerundeten Bereiche desselben Kontaktbereichs (70) befindet.

Überraschenderweise hat sich gezeigt, dass durch die besondere Anordnung der Schlitze (90) herstellungsbedingt auftretende Unebenheiten in dem modularen Metallband vermieden werden können. Dies ist wohl darauf zurückzuführen, dass aufgrund der erfindungsgemäßen Anordnung Material, das beim Prägen der Unterschneidungen (50) verdrängt wird, durch die Schlitze (90) so aufgenommen werden kann, dass Spannungen gerade im kritischen abgerundeten Bereich der Kontaktbereiche (70) abgebaut werden können.

Gemäß einer bevorzugten Ausführungsform weist das Metallband eine Dicke im Bereich von 0,03 - 0,15 mm, mehr bevorzugt im Bereich von 0,04 - 0,10 mm und ganz besonders bevorzugt im Bereich von 0,05 - 0,07 mm auf.

Gemäß einer weiteren bevorzugten Ausführungsform weisen die Unterschneidungen (50) der Kontaktbereiche (70) und gegebenenfalls des Trägerbereichs (60) eine Tiefe im Bereich von 0,005 - 0,05 mm und mehr bevorzugt im Bereich von 0,02 - 0,05 mm auf.

Gemäß einer weiteren bevorzugten Ausführungsform weist der Trägerbereich (60) eine Fläche im Bereich von 8 - 20 mm² und ganz besonders bevorzugt im Bereich von 9 - 16 mm² auf.

Gemäß einer weiteren bevorzugten Ausführungsform weisen die wenigstens zwei zueinander parallelen Seiten (62) des Trägerbereichs (60) eine Länge im Bereich von 2,5 - 4,5 mm und ganz besonders bevorzugt im Bereich von 3,0 - 4,0 mm auf.

Gemäß einer weiteren bevorzugten Ausführungsform weisen die Ausstanzungen (80), die den Trägerbereich (60) von den Kontaktbereichen (70) trennen, eine Breite im Bereich von 0,3 - 0,5 mm auf.

Die vorliegende Erfindung betrifft auch ein Verfahren zur Herstellung des vorstehend beschriebenen modularen Metallbands.

Hierzu wird zunächst eine Metallfolie (20) bereitgestellt. Bei der Metallfolie (20) handelt es sich vorzugsweise um die vorstehend definierte Metallfolie (20).

Erfingdungsgemäß werden in die Metallfolie (20) Module (11) gestanzt, die einen Trägerbereich (60), Kontaktbereiche (70), Ausstanzungen (80) und Schlitze (90) umfassen.

Die einzelnen Module (11) können ferner weitere Ausstanzungen (80) umfassen, die weitere Bereiche freigeben, um ein gewünschtes Leiterbahnmuster zu schaffen.

Daneben können die Module (11) auch Stege (110) umfassen, die vorzugsweise integral mit dem Trägerbereich (60) verbunden sind, von den Ausstanzungen (80) gebildet werden, die den Trägerbereich (60) von den Kontaktbereichen (70) trennen, und die Kontaktbereiche (70) voneinander trennen.

Hinsichtlich der weiteren Beschaffenheit der Module (11) und deren Komponenten wird auf die vorstehenden Ausführungen Bezug genommen.

Demnach weist der Trägerbereich (60) wenigstens zwei zueinander parallele Seiten (62) auf, die durch Ecken (64) begrenzt sind. Die Kontaktbereiche (70) umlaufen die wenigstens zwei zueinander parallelen Seiten (62) des Trägerbereichs (60) und die Ecken (64) der wenigstens zwei zueinander parallelen Seiten (62) des Trägerbereichs (60) vollständig, wobei die Kontaktbereiche (70) in den Bereichen, die die Ecken (64) der wenigstens zwei zueinander parallelen Seiten (62) des Trägerbereichs (60) umlaufen, abgerundet sind. Die Ausstanzungen (80) sind so beschaffen, dass sie den Trägerbereich (60) von den Kontaktbereichen (70) trennen. Ferner weisen die Kontaktbereiche (70) in den abgerundeten Bereichen Schlitze (90) auf, die mit den Ausstanzungen (80) in Verbindung stehen.

Hinsichtlich der Beschaffenheit des Trägerbereichs (60), der Kontaktbereiche (70), der Ausstanzungen (80) und der Schlitze (90 bzw. (100)) wird auf die vorstehenden Ausführungen verwiesen.

Das Stanzen kann in einem oder mehreren Schritten erfolgen. Für den Stanzvorgang können vorzugsweise herkömmliche Stanzwerkzeuge verwendet werden.

Beispielsweise ist es möglich, ein Stanzwerkzeug einzusetzen, das beim Stanzprozess in einem Schritt die Ausstanzungen (80), die den Trägerbereich (60) und die Kontaktbereiche (70) freigeben, sowie die Schlitze (90 bzw. 100) und gegebenenfalls weitere Ausstanzungen erzeugt.

Alternativ dazu können jedoch auch zwei oder mehr Stanzwerkzeuge verwendet werden, wobei das erste Stanzwerkzeug die Ausstanzungen (80), die den Trägerbereich (60) und die Kontaktbereiche (70) freigeben, und das zweite Stanzwerkzeug die erfindungsgemäßen Schlitze (90) erzeugt.

Die Technik des Stanzens von Modulen in Metallbändern ist bekannt. In diesem Zusammenhang kann auf die einschlägige Fachliteratur verwiesen werden.

Im Anschluss an den Stanzprozess werden die Unterschneidungen (50) erzeugt. Die Unterschneidungen (50) befinden sich wenigstens in den Kontaktbereichen (70), können sich zusätzlich jedoch auch im Trägerbereich (60) befinden. Diese Unterschneidungen (50) stehen mit den Ausstanzungen (80) in Fließverbindung.

Zur Schaffung dieser Unterschneidungen (50) werden die Kontaktbereiche (70) und gegebenenfalls der Trägerbereich (60) mit einem Prägewerkzeug bearbeitet. Dieses Prägewerkzeug prägt Unterschneidungen (50) in den Bereich der Kontaktbereiche (70) und gegebenenfalls des Trägerbereichs (60), der der Oberfläche, die später beim Einsatz des Moduls (11) das elektronische Bauelement (30) aufnimmt, abgewandt ist.

Die Technik des Prägens von Unterschneidungen in Metallbänder ist bekannt. Auch in diesem Zusammenhang kann auf die einschlägige Fachliteratur verwiesen werden.

Bei diesem Prägevorgang wird Material der Metallfolie (20) verdrängt. Dieses verdrängte Material kann nur in Bereiche abfließen, die frei von Metallfolie (20) sind. Diesbezüglich kommen insbesondere die Ausstanzungen (80) in Betracht, die den Trägerbereich (60) und die Kontaktbereiche (70) voneinander trennen und mit den geprägten Unterschneidungen (50) in Fließverbindung stehen.

Gemäß den aus dem Stand der Technik bekannten Verfahren führt das verdrängte Material zu Spannungen. Insbesondere fließt das verdrängte Material nicht nur in die Ausstanzungen (80), sondern setzt sich auch unter die Kontaktbereiche (70) und führt zu Unebenheiten in diesem Bereich des Metallbands. Diese Effekte treten vor allem in Bereichen auf, in denen der Prägeverlauf nicht gerade, sondern gekrümmt ist.

Aufgrund der erfindungsgemäß vorgesehenen Schlitze (90) kann beim Prägevorgang das verdrängte Material insbesondere in dem von Spannungen und damit Unebenheiten besonders betroffenen abgerundeten Bereich der Kontaktbereiche (70) vollständig vermieden werden. Dies ist darauf zurückzuführen, dass die Schlitze (90) Aussparungen zur Verfügung stellen, die das beim Prägen verdrängte Material aufnehmen und so für einen Spannungsabbau sorgen, der das Entstehen von Unebenheiten in dem Metallband wirksam unterbindet.

Erfindungsgemäß kann es auch vorgesehen sein, dass das Stanzen der Ausstanzungen (80) und das Prägen der Unterschneidungen (50) in nur einem Arbeitsschritt unter Verwendung eines kombinierten Stanz- und Prägewerkzeugs erfolgt.

Die vorliegende Erfindung betrifft ferner ein Bauteil (10), das ein Modul (11) des vorstehend beschriebenen Metallbands sowie ein elektronisches Bauelement (30) umfasst.

Das Modul (11) weist einen Trägerbereich (60) für die Aufbringung eines elektronischen Bauelements (30), der wenigstens zwei zueinander parallele Seiten (62) aufweist, die durch Ecken (64) begrenzt sind, Kontaktbereiche (70), die die wenigstens zwei zueinander parallelen Seiten (62) des Trägerbereichs (60) und die Ecken (64) der wenigstens zwei zueinander parallelen Seiten (62) des Trägerbereichs (60) vollständig umlaufen, wobei die Kontaktbereiche (70) in den Bereichen, die die Ecken (64) der wenigstens zwei zueinander parallelen Seiten (62) des Trägerbereichs (60) umlaufen, abgerundet sind, und Ausstanzungen (80), die den Trägerbereich (60) von den Kontaktbereichen (70) trennen, auf, wobei wenigstens die Kontaktbereiche (70) Unterschneidungen (50) aufweisen, die mit den Ausstanzungen (80) in Verbindung stehen und die Kontaktbereiche (70) in den abgerundeten Bereichen Schlitze (90) aufweisen, die mit den Ausstanzungen (80) in Verbindung stehen.

Hinsichtlich der Beschaffenheit des Moduls (11) und der Komponenten des Moduls (11) kann auf die vorstehenden Ausführungen Bezug genommen werden.

Das Bauteil (10) umfasst ferner ein elektronisches Bauelement (30). Bei diesem elektronischen Bauelement (30) handelt es sich vorzugsweise um einen integrierten Schaltkreis, insbesondere einen Chip.

Das elektronische Bauteil (30) ist erfindungsgemäß auf dem Trägerbereich (60) des Moduls (11) aufgebracht. Dort wird das elektronische Bauelement (30) fixiert. Die Fixierung erfolgt erfindungsgemäß durch Vergussmasse (40).

Bei der Vergussmasse (40) handelt es sich vorzugsweise um eine polymerisierbare Monomermischung. Solche Vergussmassen (40) sind aus dem Stand der Technik bekannt.

Folglich ist das elektronische Bauelement (30) mit Vergussmasse (40) überzogen. Die Vergussmasse (40) befindet sich ferner in den Unterschneidungen (50) der Kontaktbereiche (70) und gegebenenfalls des Trägerbereichs (60). Dabei kommt es zu einer Verankerung der das elektronische Bauelement (30) umgebenden Vergussmasse (40) mit den Kontaktbereichen (70) und gegebenenfalls dem Trägerbereich (60).

Gemäß einer bevorzugten Ausführungsform enthält das Bauteil (10) ferner Bonddrähte, wobei das eine Ende jedes Bonddrahts auf dem elektronischen Bauelement (30) und das andere Ende auf einem der Kontaktbereiche (70) angeordnet ist. Diese Bonddrähte dienen vornehmlich der elektrischen Kontaktierung von elektronischem Bauelement (30) und Kontaktbereichen (70).

## Patentansprüche

1. Modulares Metallband, wobei das einzelne Modul (11)
einen Trägerbereich (60) für die Aufbringung eines elektronischen Bauelements (30), der wenigstens zwei zueinander parallele Seiten (62) aufweist, die durch Ecken (64) begrenzt sind,
Kontaktbereiche (70), die die wenigstens zwei zueinander parallelen Seiten (62) des Trägerbereichs (60) und die Ecken (64) der wenigstens zwei zueinander parallelen Seiten des (62) Trägerbereichs (60) vollständig umlaufen, wobei die Kontaktbereiche (70) in den Bereichen, die die Ecken (64) der wenigstens zwei zueinander parallelen Seiten (62) des Trägerbereichs (60) umlaufen, abgerundet sind, und
Ausstanzungen (80), die den Trägerbereich (60) von den Kontaktbereichen (70) trennen, enthält,
wobei wenigstens die Kontaktbereiche (70) Unterschneidungen (50) aufweisen, die mit den Ausstanzungen (80) in Verbindung stehen,
**dadurch gekennzeichnet, dass**
die Kontaktbereiche (70) in den abgerundeten Bereichen Schlitze (90) aufweisen, die mit den Ausstanzungen (80) in Verbindung stehen.

2. Modulares Metallband nach Anspruch 1, **dadurch gekennzeichnet, dass** auch der Trägerbereich (60) Unterschneidungen (50) aufweist.

3. Modulares Metallband nach Anspruch 1 oder 2, **dadurch gekennzeichnet, dass** die Module (11) Stege (110) aufweisen, die integral mit dem Trägerbereich (60) verbunden sind, von den Ausstanzungen (80) gebildet werden, die den Trägerbereich (60) von den Kontaktbereichen (70) trennen, und die Kontaktbereiche (70) voneinander trennen.

4. Modulares Metallband nach einem der Ansprüche 1 - 3, **dadurch gekennzeichnet, dass** das Metallband eine Dicke im Bereich von 0,03 - 0,15 mm aufweist.

5. Modulares Metallband nach einem der Ansprüche 1 - 4, **dadurch gekennzeichnet, dass** die Unterschneidungen (50) der Kontaktbereiche (70) und gegebenenfalls des Trägerbereichs (60) eine Tiefe im Bereich von 0,005 - 0,05 mm aufweisen.

6. Verfahren zur Herstellung eines modularen Metallbands gemäß einem der Ansprüche 1 - 5, bei dem man
(i) eine Metallfolie (20) bereitstellt,
(ii) in die Metallfolie (20) Module (11) stanzt, die einen Trägerbereich (60), Kontaktbereiche (70), Ausstanzungen (80) und Schlitze (90) umfassen,
wobei der Trägerbereich (60) wenigstens zwei zueinander parallele Seiten (62) aufweist, die durch Ecken (64) begrenzt sind,
die Kontaktbereiche (70) die wenigstens zwei zueinander parallelen Seiten (62) des Trägerbereichs (60) und die Ecken (64) der wenigstens zwei zueinander parallelen Seiten (62) des Trägerbereichs (60) vollständig umlaufen, wobei die Kontaktbereiche (70) in den Bereichen, die die Ecken (64) der wenigstens zwei zueinander parallelen Seiten (62) des Trägerbereichs (60) umlaufen, abgerundet sind,
die Ausstanzungen (80) den Trägerbereich (60) von den Kontaktbereichen (70) trennen und
die Schlitze (90) in den abgerundeten Bereichen der Kontaktbereiche (70) angebracht sind und mit den Ausstanzungen (80) in Verbindung stehen, und
(iii) die Kontaktbereiche (70) mit Prägungen versieht, um Unterschneidungen (50) zu schaffen, die mit den Ausstanzungen (80) in Verbindung stehen.

7. Bauteil (10) umfassend
(i) ein Modul (11) eines modularen Metallbands, aufweisend
einen Trägerbereich (60) für die Aufbringung eines elektronischen Bauelements (30), der wenigstens zwei zueinander parallele Seiten (62) aufweist, die durch Ecken (64) begrenzt sind,
Kontaktbereiche (70), die die wenigstens zwei zueinander parallelen Seiten (62) des Trägerbereichs (60) und die Ecken (64) der wenigstens zwei zueinander parallelen Seiten (62) des Trägerbereichs (60) vollständig umlaufen, wobei die Kontaktbereiche (70) in den Bereichen, die die Ecken (64) der wenigstens zwei zueinander parallelen Seiten (62) des Trägerbereichs (60) umlaufen, abgerundet sind, und
Ausstanzungen (80), die den Trägerbereich (60) von den Kontaktbereichen (70) trennen,
wobei wenigstens die Kontaktbereiche (70) Unterschneidungen (50) aufweisen, die mit den Ausstanzungen (80) in Verbindung stehen,
**dadurch gekennzeichnet, dass**
die Kontaktbereiche (70) in den abgerundeten Bereichen Schlitze (90) aufweisen, die mit den Ausstanzungen (80) in Verbindung stehen, und
(ii) ein elektronisches Bauelement (30), das auf dem Trägerbereich (60) des Moduls (11) aufgebracht ist, wobei das elektronische Bauelement (30) von Vergussmasse (40) überzogen ist und sich Vergussmasse (40) in den Unterschneidungen (50) befindet, um eine Verankerung der das elektronische Bauelement (30) umgebenden Vergussmasse (40) mit den Kontaktbereichen (70) zu schaffen.

8. Bauteil (10) nach Anspruch 7, **dadurch gekennzeichnet, dass** auch der Trägerbereich (60) Unterschneidungen (50) aufweist.

9. Bauteil (10) nach Anspruch 7 oder 8, **dadurch gekennzeichnet, dass** die Module (11) Stege (110) aufweisen, die integral mit dem Trägerbereich (60) verbunden sind, von den Ausstanzungen (80) gebildet werden, die den Trägerbereich (60) von den Kontaktbereichen (70) trennen, und die Kontaktbereiche (70) voneinander trennen.

10. Bauteil (10) nach einem der Ansprüche 7 - 9, **dadurch gekennzeichnet, dass** das Metallband eine Dicke im Bereich von 0,04 - 0,08 mm aufweist und die Unterschneidungen (50) der Kontaktbereiche (70) und gegebenenfalls des Trägerbereichs (60) eine Tiefe im Bereich von 0,002 - 0,035 mm aufweisen.

## Claims

1. Modular metal tape, whereby the individual module (11) contains
a carrier region (60) for application of an electronic component (30), which carrier region has at least two sides (62) that are parallel to each other and are bordered by corners (64),
contact regions (70) that extend fully around the at least two sides (62) of the carrier region (60) that are parallel to each other and around the corners (64) of the at least two sides (62) of the carrier region (60) that are parallel to each other, whereby those regions of the contact regions (70) that extend around the corners (64) of the at least two sides (62) of the carrier region (60) that are parallel to each other, are rounded, and
blankings (80) that separate the carrier region (60) from the contact regions (70),
whereby at least the contact regions (70) comprise undercuts (50) that are connected to the blankings (80),
**characterised in that**
the contact regions (70), in the rounded regions, comprise slits (90) that are connected to the blankings (80).

2. Modular metal tape according to claim 1, **characterised in that** the carrier region (60) also comprises undercuts (50).

3. Modular metal tape according to claim 1 or 2, **characterised in that** the modules (11) comprise fins (110) that are integrally connected to the carrier region (60), are formed through the blankings (80) separating the carrier region (60) from the contact regions (70), and separate the contact regions (70) from each other.

4. Modular metal tape according to any one of the claims 1 - 3, **characterised in that** the thickness of the metal tape is in the range of 0.03 - 0.15 mm.

5. Modular metal tape according to any one of the claims 1 - 4, **characterised in that** the depth of the undercuts (50) of the contact regions (70) and, if applicable, of the carrier region (60) is in the range of 0.005 - 0.05 mm.

6. Method for producing a modular metal tape according to any one of the claims 1 - 5, in which
(i) a metal foil (20) is provided,
(ii) modules (11) comprising a carrier region (60), contact regions (70), blankings (80), and slits (90) are punched into the metal foil (20),
whereby the carrier region (60) comprises at least two sides (62) that are parallel to each other and are bordered by corners (64),
the contact regions (70) extend fully around the at least two sides (62) of the carrier region (60) that are parallel to each other and around the corners (64) of the at least two sides (62) of the carrier region (60) that are parallel to each other, whereby those regions of the contact regions (70) that extend around the corners (64) of the at least two sides (62) of the carrier region (60) that are parallel to each other, are rounded,
the blankings (80) separate the carrier region (60) from the contact regions (70), and
the slits (90) are provided in the rounded regions of the contact regions (70) and are connected to the blankings (80), and
(iii) the contact regions (70) are provided with embossings in order to generate undercuts (50) that are connected to the blankings (80).

7. Sub-assembly (10), comprising
(i) a module (11) of a modular metal tape, comprising
a carrier region (60) for application of an electronic component (30), which carrier region has at least two sides (62) that are parallel to each other and are bordered by corners (64),
contact regions (70) that extend fully around the at least two sides (62) of the carrier region (60) that are parallel to each other and around the corners (64) of the at least two sides (62) of the carrier region (60) that are parallel to each other, whereby those regions of the contact regions (70) that extend around the corners (64) of the at least two sides (62) of the carrier region (60) that are parallel to each other, are rounded, and
blankings (80) that separate the carrier region (60) from the contact regions (70),
whereby at least the contact regions (70) comprise undercuts (50) that are connected to the blankings (80),
**characterised in that**
the contact regions (70), in the rounded regions, comprise slits (90) that are connected to the blankings (80), and
(ii) an electronic component (30) that is applied to the carrier region (60) of the module (11), whereby the electronic component (30) is covered by casting compound (40) and casting compound (40) is situated in the undercuts (50) in order to generate an anchoring of the casting compound (40) surrounding the electronic component (30) to the contact regions (70).

8. Sub-assembly (10) according to claim 7, **characterised in that** the carrier region (60) also comprises undercuts (50).

9. Sub-assembly (10) according to claim 7 or 8, **characterised in that** the modules (11) comprise fins (110) that are integrally connected to the carrier region (60), are formed through the blankings (80) separating the carrier region (60) from the contact regions (70), and separate the contact regions (70) from each other.

10. Sub-assembly (10) according to any one of the claims 7 - 9, **characterised in that** the depth of the metal tape is in the range of 0.04 - 0.08 mm and the depth of the undercuts (50) of the contact regions (70) and, if applicable, of the carrier region (60) is in the range of 0.002 - 0.035 mm.

## Revendications

1. Bande métallique modulaire, dans laquelle le module unitaire (11) contient
une partie support (60) pour la mise en place d'un composant électronique (30) qui présente au moins deux côtés (62) parallèles l'un à l'autre qui sont délimités par des coins (64),
des zones de contact (70), qui entourent totalement les au moins deux côtés (62) parallèles l'un à l'autre de la partie support (60) et les coins (64) des au moins deux côtés (62) parallèles l'un à l'autre de la partie support (60), où les zones de contact (70) sont arrondies dans les zones qui entourent les coins (64) des au moins deux côtés (62) parallèles l'un à l'autre de la partie support (60), et
des découpes (80) qui séparent la partie support (60) des zones de contact (70),
dans laquelle les zones de contact (70) présentent des crénages (50) qui sont en communication avec les découpes (80),
**caractérisée en ce que**
les zones de contact (70) présentent des fentes (90) dans les zones arrondies qui sont en communication avec les découpes (80).

2. Bande métallique modulaire selon la revendication 1, **caractérisée en ce que** la partie support (60) présente également des crénages (50).

3. Bande métallique modulaire selon les revendications 1 ou 2, **caractérisée en ce que** les modules (11) présentent des pontages (110), qui sont intégralement reliés avec la partie support (60), sont formés par les découpes (80) qui séparent la partie support (60) des zones de contact (70), et séparent les zones de contact (70) les unes des autres.

4. Bande métallique modulaire selon l'une des revendications 1 à 3, **caractérisée en ce que** la bande métallique présente une épaisseur dans la gamme de 0,03 à 0,15 mm.

5. Bande métallique modulaire selon l'une des revendications 1 à 4, **caractérisée en ce que** les crénages (50) des zones de contact (70), et éventuellement de la partie support (60), présentent une profondeur dans la gamme 0,005 à 0,05 mm.

6. Procédé de fabrication d'une bande métallique modulaire selon l'une des revendications 1 à 5, dans lequel on
(i) fournit une feuille métallique (20),
(ii) estampe des modules (11) dans la feuille métallique (20), qui comprennent une partie support (60), des zones de contact (70), des découpes (80) et des fentes (90),
où la partie support (60) présente au moins deux côtés (62) parallèles l'un à l'autre, qui sont délimités par des coins (64),
les zones de contact (70) qui entourent totalement les au moins deux côtés (62) parallèles l'un à l'autre de la partie support (60) et les coins (64) des au moins deux côtés (62) parallèles l'un à l'autre de la partie support (60), où les zones de contact (70) sont arrondies dans les zones qui entourent les coins (64) des au moins deux côtés (62) parallèles l'un à l'autre de la partie support (60),
les découpes (80) séparent la partie support (60) des zones de contact (70), et
les fentes (90) sont rapportées dans les zones arrondies des zones de contact (70) et sont en communication avec les découpes (80), et
(iii) munit les zones de contact (70) d'empreintes afin d'aménager des crénages (50) qui sont en communication avec les découpes (80).

7. Composant (10) comprenant
(i) un module (11) d'une bande métallique modulaire présentant
une partie support (60) pour la mise en place d'un composant électronique (30) qui présente au moins deux côtés (62) parallèles l'un à l'autre qui sont limités par des coins (64),
des zones de contact (70), qui entourent totalement les au moins deux côtés (62) parallèles l'un à l'autre de la partie support (60) et les coins (64) des au moins deux côtés (62) parallèles l'un à l'autre de la partie support (60), où les zones de contact (70) sont arrondies dans les zones qui entourent les coins (64) des au moins deux côtés (62) parallèles l'un à l'autre de la partie support (60), et
des découpes (80) qui séparent la partie support (60) des zones de contact (70),
où les zones de contact (70) présentent des crénages (50) qui sont en communication avec les découpes (80),
**caractérisé en ce que**
les zones de contact (70) présentent des fentes (90) dans les zones arrondies qui sont en communication avec les découpes (80), et
(ii) un composant électronique (30) qui est rapporté sur la partie support (60) du module (11), où le composant électronique (30) est revêtu d'une masse de scellement (40) et la masse de scellement (40) se trouve dans les crénages (50), afin d'effectuer un ancrage de la masse de scellement (40) entourant le composant électronique (30) avec les zones de contact (70).

8. Composant (10) selon la revendication 7, **caractérisé en ce que** la partie support (60) présente également des crénages (50).

9. Composant (10) selon les revendications 7 ou 8, **caractérisé en ce que** les modules (11) présentent des pontages (110) qui sont intégralement reliés avec la partie support (60), sont formées par les découpes (80) qui séparent la partie support (60) des zones de contact (70), et séparent les zones de contact (70) les unes des autres.

10. Composant (10) selon l'une des revendications 7 à 9, **caractérisé en ce que** la bande métallique présente une épaisseur dans la gamme de 0,04 à 0,08 mm et les crénages (50) des zones de contact (70) et, éventuellement, de la partie support (60), présentent une profondeur de la gamme de 0,002 à 0,035 mm.
